# EUROPÄISCHE PATENTSCHRIFT

(11) **EP 1 907 597 B1**
(45) Veröffentlichungstag und Bekanntmachung des Hinweises auf die Patenterteilung: **29.04.2009**
(21) Anmeldenummer: 05775812.0
(22) Anmeldetag: 27.07.2005
(51) Int. Cl.: C23C 14/26

(54) **VORRICHTUNG ZUM EINSPANNEN UND POSITIONIEREN EINES VERDAMPFERSCHIFFCHENS**
DEVICE FOR CLAMPING AND POSITIONING AN EVAPORATOR BOAT
DISPOSITIF DE FIXATION ET DE POSITIONNEMENT D'UNE NACELLE D'EVAPORATION

(43) Veröffentlichungstag der Anmeldung: 09.04.2008
(73) Patentinhaber: Applied Materials GmbH & Co. KG, 63755 Alzenau (DE)
(72) Erfinder: HEIN, Stefan, 63825 Blankenbach (DE); KLEIN, Wolfgang, 63939 Wörth (DE)
(74) Vertreter: Bockhorni & Kollegen
(86) Internationale Anmeldenummer: PCT/EP2005/008154
(87) Internationale Veröffentlichungsnummer: WO 2007/012342

(56) Entgegenhaltungen:
- DE-B- 1 237 401
- US-A- 5 068 915

## Beschreibung

Die Erfindung betrifft eine Vakuumbehandlungsanlage gemäß dem Oberbegriff von Anspruch 1 und einen Verdampfer für Vakuumbeschichtungsanlagen gemäß dem Oberbegriff von Anspruch 17.

Verdampfer werden insbesondere für die Vakuumaufdampfung von dünnen Schichten auf Unterlagen benutzt. Moderne Verdampfer für eine großflächige Bedampfung, insbesondere bei Bandbedampfungsanlagen, bestehen aus einem Verdampferschiffchen, das fest zwischen zwei Strom führenden Zuleitungen eingespannt wird. Im Betrieb des Verdampfers muss zwischen den Zuleitungen, bei denen eine meist als Strom führend und eine als Masse ausgelegt ist, und dem Verdampferschiffchen ein optimaler elektrischer Kontakt sichergestellt werden. Gleichzeitig sollen die Verdampferschiffchen aber möglichst einfach auswechselbar sein.

Aus dem Stand der Technik sind verschiedene Ausführungsformen solcher Verdampfer bekannt. So beschreibt z. B. die US 3,387,116 einen Verdampfer, bei dem ein trogförmiges Verdampferschiffchen zwischen einer ersten ortsfesten, stützenförmigen Zuleitung und einem unter Federspannung stehenden, an einer zweiten ortsfesten Zuleitung gehaltenen und geführten Druckstück eingespannt ist. Dieser Verdampfer hat den Nachteil, dass das Austauschen des Verdampferschiffchens zeitraubend ist, da für den Austausch die Federspannung mit Hilfe von Werkzeugen verringert werden muss, und die Entnahme des Schiffchens unbequem ist, da dieses nur schwer zugänglich ist.

Eine dahingehend verbesserte Verdampfervariante beschreibt die DE 40 15 385, bei der das Verdampferschiffchen zwischen zwei stützenförmig ausgebildeten und mit backenförmigen Aufnahmen versehenen Zuleitungen mittels Federkraft eingespannt ist, und die Federkraft durch ein Exzenterelement einstellbar ist. Weiterhin weist dieser Verdampfer eine Kühlung der Strom führenden Zuleitung auf sowie Schutzeinrichtungen, um die Gleitlager der verschiebbaren Strom führenden Zuleitung gegenüber einer Verschmutzung oder Verstopfung zu schützen. Nachteilig an diesem Verdampfer ist jedoch dessen komplizierter konstruktiver Aufbau. Zusätzlich ist er einem relativ großen Verschleiß durch die prozessbedingt starke Verschmutzung unterworfen.

Neuerdings werden in Vakuumsbehandlungsanlagen Verdampfer verwendet, bei denen das Verdampferschiffchen zwischen einem feststehenden Massebolzen und einem axial beweglichen Strombolzen eingespannt wird. Der Strombolzen wird über radiale Gleitlager elektrisch isoliert im Inneren einer Führungshülse geführt, die einen Flansch aufweist, der äußerlich mit der Kammerwand der Prozesskammer verschraubt ist und so eine Abdichtung des Verdampfers gegen Atmosphärendruck sicherstellt. Die Führungshülse muss wegen der Führung des Strombolzens relativ lang ausgeführt sein und ragt vollständig in die Prozesskammer hinein. Im Betriebszustand wird die Kraft zum Einspannen des Verdampferschiffchens allein über die Druckdifferenz zwischen Atmosphärendruck und Prozesskammerdruck aufgebracht, während im Wartungszustand eine im Inneren der Führungshülse gegen den Strombolzen wirkende Druckfeder eine Vorspannung des Verdampferschiffchens bewirkt. Nachteilig an dieser Ausführung ist die Anfälligkeit der Gleitlager und Dichtstellen gegenüber der prozessbedingten starken Verschmutzung, die durch Abrieb in dem Gleitlager und durch die Prozessatmosphäre selbst entsteht. Außerdem erfordert die Konstruktion sehr enge Fertigungstoleranzen, was zu hohen Kosten führt. Außerdem ist die Verdampferbank durch die Fixierung der Strombolzen in ihrer Position in der Anlage festgelegt und kann insbesondere senkrecht zu den Vakuumschiebedurchfübrungen nicht oder nur mit erheblichem Konstruktionsaufwand versetzt werden, um z. B. eine Änderung des Abstandes der Verdampferschiffchen zum Substrat hin vorzunehmen.

Aufgabe der vorliegenden Erfindung ist es, eine Vakuumbehandlungsanlage mit einem Verdampfer und einen Verdampfer der vorbeschriebenen Art aufzuzeigen, bei dem eine sichere elektrische Kontaktierung zwischen den Zuleitungen und dem Verdampferschiffchen gewährleistet wird, jedoch die Nachteile des oben beschriebenen Stands der Technik vermieden werden.

Diese Aufgabe wird gelöst durch eine Vakuumbehandlungsanlage gemäß Anspruch 1 und einen Verdampfer gemäß Anspruch 17. Vorteilhafte Weiterbildungen der vorliegenden Erfindung sind Gegenstand der Unteransprüche.

Erfindungsgemäß wird die verschiebbare Zuleitung des Verdampfers in einer Vakuumsbehandlungsanlage, die vorzugsweise als Strom führende Leitung ausgeführt ist, im Wesentlichen über eine Parallelogrammführung geführt. Diese Parallelogrammführung bewirkt eine zwangsweise Führung der verschiebbaren Zuleitung gegenüber der anderen Zuleitung und dem Verdampferschiffchen.

Eine Parallelogrammführung zeichnet sich aus durch jeweils zwei parallel zueinander angeordnete Elemente, die ein Parallelogramm bilden. Da bei einem Parallelogramm die Innenwinkelsumme immer 360° beträgt und diagonal gegenüberliegende Winkel gleich sind, können zwei gegenüberliegende Seiten, beispielsweise die verschiebbare Zuleitung eines Verdampfers in Bezug auf eine Basis, nur parallel zueinander verschoben werden.

Allerdings kann auch eine dahingehend abgewandelte Parallelogrammführung eingesetzt werden, bei der zwei gegenüberliegende Seiten weder parallel noch gleich lang ausgebildet sind. In diesem Fall, in dem beispielsweise zwischen der Basis und der verschiebbaren Zuleitung zwei unterschiedlich lange Abstandselemente gelenkig angeordnet sind und das längere Abstandselement eine größere Neigung zwischen Basis und der Zuleitung aufweist als das kürzere Abstandselement, kann dennoch in einem Bereich geringer Auslenkung eine im wesentlichen parallele Verschiebung der Zuleitung in Bezug auf die Basis sichergestellt werden. Da bei einem Verdampfer nur geringe Verschiebungen der beweglichen Zuleitung gegenüber dem Verdampferschiffchen und der festen Zuleitung notwendig sind, können bei der erfindungsgemäßen Vakuumbehandlungsanlage und dem erfindungsgemäßen Verdampfer auch solche abgewandelten Parallelogrammführungen zum Einsatz kommen.

Erfindungsgemäß umfasst die Vakuumbehandlungsanlage also mindestens einen Verdampfer mit einer Vorrichtung zum Führen einer verschiebbaren Zuleitung zum Einspannen und Positionieren eines Verdampferschiffchens, wobei die Vorrichtung als Parallelogrammführung eine Basis aufweist, an der eine Zuleitung über zwei Abstandselemente beweglich verbunden ist, wobei die Abstandselemente eine solche Länge und Anordnung zwischen Basis und Zuleitung aufweisen, dass zumindest über einen kleinen Auslenkungsbereich der Abstandselemente eine im Wesentlichen parallel zur Einspannrichtung erfolgende Führung der Zuleitung ermöglicht wird.

Gegenüber bisherig verwendeten Führungen der verschiebbaren Zuleitung weist diese Parallelogrammführung einen einfacheren Aufbau auf, wodurch die erfindungsgemäße Vakuumbehandlungsanlage und der erfindungsgemäße Verdampfer wesentlich kostengünstiger sind als bisherige Ausführungsformen. Zusätzlich weist die Parallelogrammführung keine aufeinander gleitenden Flächen oder Dichtungen auf, wodurch der erfindungsgemäße Verdampfer und die erfindungsgemäße Vakuumbehandlungsanlage eine wesentlich geringere Anfälligkeit gegenüber der prozessbedingt starken Verschmutzung, z. B. durch Aluminium- und Zinkstäube, aufweisen. Weiterhin entfällt bei dem erfindungsgemäßen Verdampfer eine die verschiebbare Zuleitung umgebende Führungshülse. Dadurch ist der Verdampfer schmaler ausgeführt und es können gegenüber bisherigen Ausführungsformen engere Verdampferschiffchenabstände erreicht werden, wodurch ein Leistungssteigerungspotential bei Reihenverdampfern, also mehrfach parallel angeordneten Verdampferschiffchen, erzielt werden kann.

Nach einer vorteilhaften Ausgestaltung ist mindestens ein Abstandselement steif ausgeführt und mittels Gelenkverbindungen an Basis und beweglicher Zuleitung angeordnet. Andererseits kann mindestens ein Abstandselement auch als Blatt- bzw. Rechteckfeder ausgeführt sein. Vorteilhaft stellt nämlich eine solche Blattfeder zugleich eine Vorspannkraft zur Verfügung, die in Einspannrichtung wirkt.

Falls zwei steife Abstandselemente verwendet werden, werden bevorzugt Mittel zum Bereitstellen dieser Vorspannkraft vorgesehen, wobei die Vorspannkraft insbesondere 50 N betragen soll. Mit Hilfe dieser Vorspannkraft kann im Wartungszustand, wenn also keine Einspannkraft durch geeignete Mittel zur Verfügung gestellt wird, eine Vorspannkraft auf das Verdampferschiffchen zwischen den beiden Zuleitungen bereit gestellt werden, die ein sicheres Positionieren des Verdampferschiffchens gewährleistet.

Besonders bevorzugt weist die Führung mindestens ein vertikales Anschlagselement auf zur Begrenzung der Verschiebungsmöglichkeit der beweglichen Zuleitung auf die Basis zu. Damit wird besonders bei Abstandselementen, die als Blattfedern ausgeführt sind, verhindert, dass diese im Wartungszustand geknickt werden können.

Weiterhin ist es von Vorteil, wenn mindestens ein horizontaler Anschlag zur Begrenzung der Verschiebung der verschiebbaren Zuleitung in Einspannrichtung vorgesehen ist. Dadurch kann zum einen die Verschiebung auf den Bereich begrenzt werden, in dem sie noch weitgehend parallel zur Einspannrichtung erfolgt, und zum anderen wird so verhindert, dass die Elemente der Parallelogrammführung übermäßigen Belastungen, wie sie im Wartungszustand durch unsachgemäße Handhabung auftreten können, ausgesetzt werden.

Vorteilhaft ist die verschiebbare Zuleitung an einer Platte angeordnet, wobei die Abstandselemente an der Platte angeordnet sind. Falls die Platte selbst oder eine Zwischenlage zwischen Platte und Zuleitung elektrisch isolierend ist, kann die Zuleitung besonders einfach von der Führung elektrisch isoliert werden.

Besonders vorteilhaft werden nun zwei horizontale Anschläge dadurch ausgebildet, dass die Platte seitlich hervorstehende Vorsprünge aufweist, die komplementär ausgebildet sind zu zwei Backen, die an dem oder den vertikalen Anschlagselementen angeordnet sind. Auf diese Weise lassen sich die horizontalen Anschläge und das vertikale Anschlagselement konstruktiv besonders einfach in die Führung integrieren.

Im Betriebszustand wird der Einspanndruck, der das Verdampferschiffchen zwischen den beiden Zuleitungen einspannt, vorteilhaft durch eine auf die bewegliche Zuleitung direkt oder auf die Platte wirkende Druckfeder bereitgestellt, so dass unter allen Betriebsbedingungen eine optimale elektrische Kontaktierung des Verdampferschiffchens sichergestellt wird. Besonders bevorzugt ist zur Be- und Entlastung der Druckfeder ein pneumatisches Element vorgesehen, so dass der Einspanndruck der Druckfeder im Wartungszustand des Verdampfers reduziert bzw. vollständig entfernt werden kann, so dass nur noch die Vorspannkraft der Blattfedern auf das Verdampferschiffchen wirkt.

In einer bevorzugten Ausführungsform ist die verschiebbare Zuleitung nicht einstückig ausgebildet, sondern umfasst einen Strombolzen und einen Kupferblock, an dem die Stromzuführung angeschlossen ist und der mit der Parallelogrammführung elektrisch isoliert verbunden ist. Vorteilhaft ist der Strombolzen über einen Losflansch an dem Kupferblock befestigbar, so dass eine besonders einfache Montage und Demontage der Strombolzen, die durch den Verdampferbetrieb starken Abnutzungen unterliegen, ermöglicht wird und der Strombolzen stufenlos gegenüber dem Kupferblock verdreht werden kann.

Bevorzugt weist die zweite Zuleitung einen Massebolzen auf und der Masse- und/oder der Strombolzen des Verdampfers weisen mehrere backenförmige Aufnahmen für das Verdampferschiffchen auf. Auf diese Weise können die starker Abnutzung unterliegenden Bolzen ökonomischer verwendet werden, da ihre Lebensdauer erhöht wird. Bevorzugt weist der Massebolzen vier drehsymmetrisch angeordnete backenförmige Aufnahmen rings eines quadratischen Sockels auf und die backenförmige Aufnahme des Strombolzens wird durch einen ring- oder kreisförmigen Sockel gebildet.

Zur Erhöhung der Haltbarkeit des Strombolzens weist dieser bevorzugt eine Sacklochbohrung mit einem Kühlmittelverteilerrohr auf, die mit entsprechenden Kühlwasserzu- und -ableitungen in dem Kupferblock verbunden sind, wodurch im Betrieb des Verdampfers die Temperatur der Strom führenden Zuleitung eingestellt werden kann. Es sind jedoch auch andere geeignete Kühlungsvorrichtungen der verschiebbaren Zuleitung möglich.

Eine vorteilhafte Weiterbildung besteht darin, dass der Verdampfer innerhalb der Vakuumbehandlungsanlage in Bezug auf ein zu bedampfendes Substrat justierbar ausgebildet ist. Bevorzugt ist er dabei in seinem Abstand zum Substrat justierbar. So kann z. B. die gesamte Verdampfereinheit auf einem höhenverstellbaren Element befestigt sein.

Weitere Eigenschaften, Merkmale und Vorteile der erfindungsgemäßen Vakuumbehandlungsanlage und des erfindungsgemäßen Verdampfers werden aus dem nachfolgend näher erläuterten Ausführungsbeispiel deutlich, dabei zeigen die entsprechenden Zeichnungen in
- Fig. 1: eine Seitenansicht eines Ausführungsbeispiels des erfindungsgemäßen Verdampfers im Wartungszustand,
- Fig. 2: eine Seitenansicht des Ausführungsbeispiels aus Fig. 1 mit dem erfindungsgemäßen Verdampfer im Betriebszustand,
- Fig. 3: eine Ansicht der Stirnfläche eines erfindungsgemäßen Strombolzens und
- Fig. 4: eine Ansicht der Stirnfläche eines erfindungsgemäßen Massebolzens.

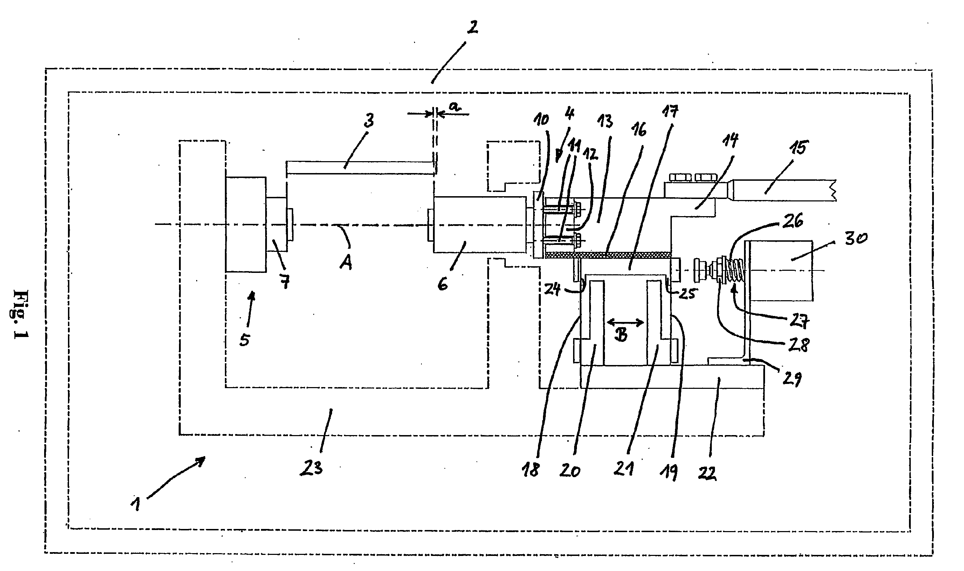

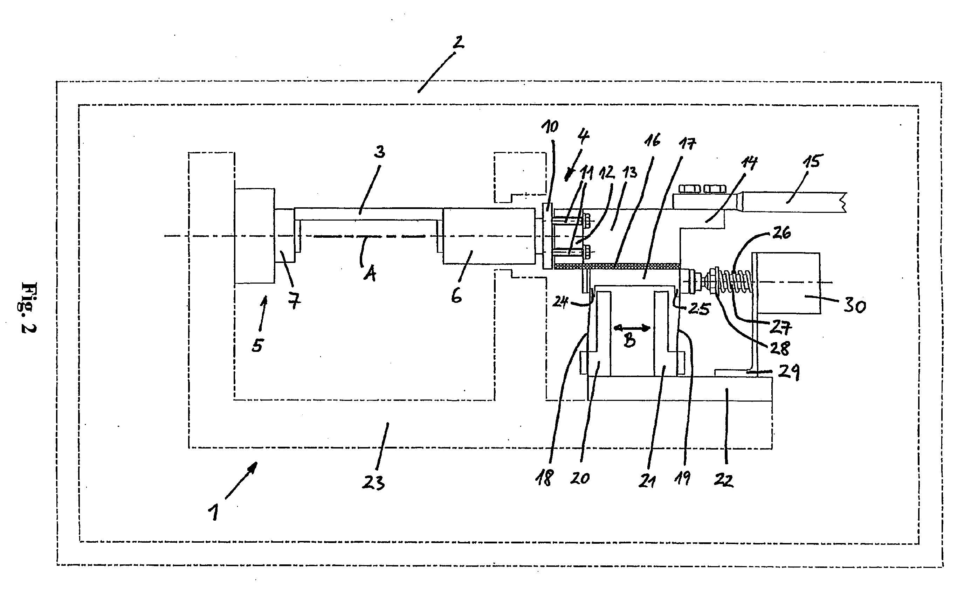

In Fig. 1 ist ein bevorzugtes Ausführungsbeispiel des erfindungsgemäßen Verdampfers 1 für Vakuumbeschichtungsanlagen im Wartungszustand dargestellt. Der Verdampfer 1 ist in einer Prozesskammer 2 der Vakuumbehandlungsanlage angeordnet und weist ein Verdampferschiffchen 3 auf, das im Wartungszustand nicht eingespannt ist und im Betriebszustand (vgl. Fig. 2) zwischen einer ersten 4 und einer zweiten Zuleitung 5 in einer Einspannrichtung A aufgenommen ist. Die erste Zuleitung 4 weist einen Strombolzen 6 auf, der ebenso wie der Massebolzen 7 der zweiten Zuleitung 5 mit einer backenförmigen Aufnahme 8, 9 versehen ist, um eine stirnseitige Aufnahme des Verdampferschiffchens 3 zu ermöglichen.

Der Strombolzen 6 weist an seinem von der Verdampferschiffchenaufnahme 8 gegenüberliegenden Ende einen Losflansch 10 auf. Mit Hilfe dieses Losflansches 10 kann der Strombolzen 6 über geeignete Befestigungsmittel, vorzugsweise Schrauben 11, formschlüssig und elektrisch leitend an der Aufnahme 12 eines Kupferblocks 13 befestigt werden. Der Kupferblock 13 weist eine weitere Aufnahme 14 auf, an der die Stromzuführung 15, im dargestellten Beispiel ein flexibles Kupferband, befestigt werden kann, so dass im Betriebszustand über den Strombolzen 6 eine Stromzuführung zu dem Verdampferschiffchen 3 erfolgt. Der Kupferblock 13 weist an seiner Unterseite eine elektrische Isolierung 16 auf, an der eine Platte 17 befestigt ist.

An der Platte 17 sind zwei Blatt- bzw. Rechteckfedern 18, 19 befestigt, die wiederum über zwei vertikale Anschlagselemente 20, 21 befestigt sind, die ihrerseits an einer Basis 22 befestigt sind. Die zwei Blattfedern 18, 19 sind planparallel zueinander jeweils mit einer Stirnseite der Platte 17 verbunden und an ihrem gegenüberliegenden Ende jeweils an den zwei vertikalen Anschlagselementen 20, 21 befestigt. Die Befestigung der Blattfedern 18, 19 an der Platte 17 und den Anschlagelementen 20, 21 kann mit jeglichen geeigneten Befestigungsmitteln, insbesondere einer Schraubbefestigung, erfolgen. Die Blattfedern 18, 19 bestehen aus einem Federstahl, wodurch die Platte 17 in Bezug zur zweiten Basis 22 verschiebbar bleibt und gleichzeitig eine Vorspannkraft bereitgestellt wird, die auf die Platte 17 wirkt, wenn die Blattfedern 18, 19 aus ihrer in Fig. 1 gezeigten Gleichgewichtslage, die sich im Wartungszustand von selbst einstellt, ausgelenkt werden. Da sowohl Platte 17 und Basis 22 als auch die beiden Blattfedern 18, 19 jeweils parallel zueinander angeordnet sind, wird eine Parallelogrammführung definiert, die eine zwangsgeführte Verschiebung der Platte 17 in Bezug zur Basis 22 in der zu Platte 17 und Basis 22 parallelen Führungsrichtung B bereitstellt. Die Basis 22 ist an einem Trägerelement 23, an der auch die feste zweite Zuleitung 5 befestigt ist, parallel zur Einspannrichtung A lösbar festgelegt und im gelösten Zustand in Einspannrichtung A beweglich. Dadurch ist die Führungsrichtung B stets parallel zur Einspannrichtung A.

Die vertikalen Anschlagselemente 20, 21 begrenzen die vertikale Auslenkung der Platte 17 auf die Basis 22 zu. Dadurch wird verhindert, dass die Blattfedern 18, 19 möglicherweise aufgrund unsachgemäßer Handhabung im Wartungszustand geknickt werden. Die Auslenkung der Platte 17 in Führungsrichtung B wird durch zwei horizontale Anschläge eingeschränkt, die durch die mit den vertikalen Anschlagselementen 20, 21 zusammenwirkenden seitlichen Vorsprüngen 24, 25 der Platte 17 gebildet sind.

Die Basis 22 ist so auf dem Trägerelement 23 in der Einspannrichtung A befestigt, dass der Abstand zwischen den backenförmigen Aufnahmen 8, 9 von Strom- und Massebolzen 6, 7 im Wartungszustand um einen Betrag a geringer ist als die Länge des Verdampferschiffchens 3. Auf diese Weise wird nach dem Einfügen des Verdampferschiffchens 3 zwischen dem Strom- 6 und dem Massebolzen 7 die erste Zuleitung 4 um den Betrag a, der vorzugsweise einige Millimeter beträgt, und die Blattfedern 18, 19 aus ihrer Gleichgewichtslange ausgelenkt, wie die S-förmige Gestalt der Blattfedern in Fig. 2 andeutet. Im Wartungszustand wird somit über die Blattfedern 18, 19 eine Vorspannkraft auf das eingefügte Verdampferschiffchen 3 bereitgestellt, die im dargestellten Beispiel 50 N beträgt. Auf diese Weise ist gewährleistet, dass das Verdampferschiffchen 3 exakt zwischen den beiden Bolzen 6, 7 positioniert werden kann und diese Position auch beibehält und dass insbesondere keine Gefahr besteht, dass das Verdampferschiffchen 3 aus dem Verdampfer 1 während der Wartung herausfällt.

Um im Betriebszustand (vgl. Fig. 2) eine Verspannung des Verdampferschiffchens 3 bereitzustellen ist eine Druckfeder 26 vorgesehen, die auf einer Welle 27 angeordnet ist und sich zwischen einer kopfartigen Verdickung der Welle 28 und einem Federanschlag 29, der an der Basis 22 befestigt ist, erstreckt. Ein pneumatisches Element 30 ist ebenfalls an dem Federanschlag 29 angeordnet und wirkt über die Welle 27 auf die Druckfeder 26 be- und entlastend.

Im Betriebszustand des Verdampfers 1 wird der Strombolzen 6 über die Druckfeder 26, die über den Wellenkopf 28 auf die Platte 17 wirkt, mit einer solchen Kraft gegen das Verdampferschiffchen 3 gepresst, dass das Verdampferschiffchen 3 zwischen Strombolzen 6 und Massebolzen 7 eingespannt ist und so ein optimaler elektrischer Kontakt zwischen diesen drei Elementen besteht. Zur besseren Kontaktierung des Verdampferschiffchens 3 und zum Ausgleich von Oberflächenrauheiten können die Backen 8, 9 der Bolzen 6, 7 mit einer Graphitfolie belegt sein. Im Wartungszustand des Verdampfers 1 zieht das pneumatische Element 30 die Welle 27 zurück, so dass die Druckfeder 26 nicht mehr auf die Platte 17 wirkt sondern nur noch die Vorspannkraft der Blattfedern 18, 19.

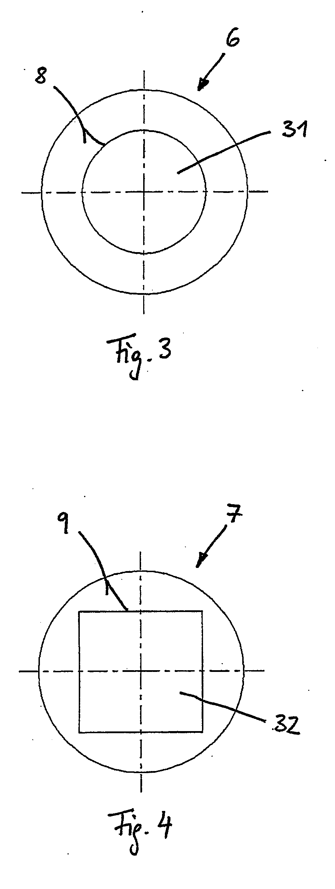

Mehrere backenförmigen Aufnahmen 8, 9 können sowohl an dem Strombolzen 6 als auch an dem Massebolzen 7 drehsymmetrisch um die Stirnseiten der vorzugsweise zylindrisch ausgebildeten Bolzen 6, 7 angeordnet sein. Vorteilhaft weist der Strombolzen 6 einen an seiner Stirnseite kreisförmig vorstehenden, axialsymmetrischen Sockel 31 auf (vgl. Fig. 3). Aufgrund des Losflansches 10 kann der Strombolzen stufenlos um die Aufnahme 12 des Kupferblocks 13 gedreht werden. Da der Strombolzen 6 aufgrund der hohen Leistungsaufnahme des Verdampferschiffchens 3 einem hohen Verschleiß unterworfen ist, kann so das Austauschintervall des Strombolzens 6 durch seine vollständige Nutzung reduziert werden. An dem Massebolzen 7 sind bevorzugt vier Aufnahmebacken 9 axialsymmetrisch durch einen quadratischen Sockel 32 gebildet, so dass Massebolzen 7 viermal verwendet werden kann (vgl. Fig. 4). Die geraden Auflageflächen des quadratischen Sockels 32 dienen dabei als Positionierhilfen für das Verdampferschiffchen 3.

Natürlich sind auch anders geformte Aufnahmebacken 8, 9 der Bolzen 6, 7 möglich, wenn die Stirnflächen des Verdampferschiffchens 3 eine andere Form aufweisen. Wünschenswert ist allerdings, dass die Stirnflächen des Verdampferschiffchens 3 vollflächig an den Backenaufnahmen 8, 9 der Bolzen 6, 7 anliegen, damit ein optimaler elektrischer Kontakt sichergestellt ist.

Zusätzlich zur gezeigten Ausführungsform gemäß Fig. 1 kann eine Wasserkühlung vorgesehen sein, die im Inneren des Kupferblocks 13 verläuft und eine Sacklochbohrung in dem Strombolzen 6 speist. Durch ein Kühlmittelverteilerrohr innerhalb des Strombolzens 6 und einen geeigneten Wasseranschluss zwischen Losflansch 10 des Strombolzens 6 und Aufnahme 12 des Kupferblocks 13 ist dann ein direkter Wasseraustausch zwischen einer Zu- und einer Ableitung und somit eine Kühlung der ersten Zuleitung 4 insgesamt möglich.

Aus obiger Beschreibung wurde klar, dass in dem erfindungsgemäßen Verdampfer die Führung der ersten Zuleitung 4 über die Parallelogrammführung konstruktiv sehr einfach und verschleißarm erfolgt. Der Verdampfer 1 weist keine aufeinander gleitenden Flächen oder Dichtungen auf Hierdurch ergibt sich insgesamt eine geringere Anfälligkeit des Verdampfers 1 gegenüber einer prozessbedingten starken Verschmutzung. Der Verdampfer 1 ist wegen des einfachen Aufbaues kostengünstiger als bisherige Verdampferausführungsformen herzustellen. Somit ist die erfindungsgemäße Vakuumbehandlungsanlage auch ökonomischer zu betreiben. Weiterhin ist der Verdampfer 1 schmaler ausgeführt als bisherige Verdampfer, so dass sich wegen des damit zu erreichenden engeren Verdampferschiffchenabstandes bei einem Reihenverdampfer insgesamt ein Leistungssteigerungspotential der erfindungsgemäßen Vakuumbehandlungsanlage durch den erfindungsgemäßen Verdampfer 1 ergibt. Außerdem ist bei dem erfindungsgemäßen Verdampfer 1 im Gegensatz zu den Verdampfern des Stands der Technik der Abstand der Verdampferschiffchen 3 zum Substrat auf einfache Weise variabel einstellbar, indem z. B. die gesamte Verdampfereinheit mit dem Trägerelement 23 auf einem höhenverstellbaren Element befestigt wird.

## Patentansprüche

1. Vakuumbehandlungsanlage, insbesondere Bandbeschichtungsanlage, mit mindestens einem in einer Prozesskammer (2) angeordneten Verdampfer (1), der ein in seiner Leistung steuerbares und durch Stromdurchgang beheiztes Verdampferschiffchen (3), zwei elektrische Zuleitungen (4, 5), zwischen denen das Verdampferschiffchen (3) einspannbar ist, wobei die erste Zuleitung (4) gegenüber der zweiten Zuleitung (5) in einer Einspannrichtung (A) verschiebbar ist, sowie eine Vorrichtung zum Führen der ersten Zuleitung (4) zum Einspannen und Positionieren des Verdampferschiffchens (3) zwischen den Zuleitungen (4, 5) aufweist,
**dadurch gekennzeichnet, dass**
die Vorrichtung zum Führen der ersten Zuleitung (4) mindestens zwei Abstandselemente (18, 19) und eine Basis (22) aufweist und die erste Zuleitung (4) mit der Basis (22) über die Abstandselemente (18, 19) beweglich verbunden ist, wobei die Abstandselemente (18, 19) an jeweils einer Seite mit der ersten Zuleitung (4) und mit der jeweils anderen Seite an der Basis (22) angeordnet sind und so eine zwangsweise Führung der ersten Zuleitung (4) ermöglichen und wobei die Abstandselemente (18, 19) eine solche Länge und Anordnung zwischen der ersten Zuleitung (4) und der Basis (22) aufweisen, dass zumindest über einen kleinen Auslenkungsbereich der Abstandselemente (18, 19) die Führungsrichtung (B) im wesentlichen parallel zur Einspannrichtung (A) ist.

2. Vakuumbehandlungsanlage gemäß Anspruch 1, **dadurch gekennzeichnet, dass** mindestens ein Abstandselement steif ausgeführt und mittels Gelenkverbindungen an der ersten Zuleitung (4) und der Basis (22) angeordnet ist.

3. Vakuumbehandlungsanlage gemäß Anspruch 1 oder 2, **dadurch gekennzeichnet, dass**
Mittel zum Bereitstellen einer Vorspannkraft, insbesondere einer Vorspannkraft von 50 N, in Einspannrichtung (A) und mindestens entgegen der zweiten Zuleitung (5) vorgesehen sind.

4. Vakuumbehandlungsanlage nach einem der Ansprüche 1 bis 3, **dadurch gekennzeichnet, dass**
mindestens ein Abstandselement (18, 19) als Blattfeder ausgeführt ist, das eine Vorspannkraft in Einspannrichtung (A) und mindestens entgegen der zweiten Zuleitung (5) bereitstellt.

5. Vakuumbehandlungsanlage gemäß einem der vorhergehenden Ansprüche, **dadurch gekennzeichnet, dass**
mindestens ein vertikales Anschlagselement (20, 21) zur Begrenzung einer Bewegung der ersten Zuleitung (4) in Richtung auf die Basis (22) zu vorgesehen ist.

6. Vakuumbehandlungsanlage gemäß einem der vorhergehenden Ansprüche, **dadurch gekennzeichnet, dass**
mindestens ein horizontaler Anschlag (20, 24, 21, 25) zur Begrenzung der Verschiebung der ersten Zuleitung (4) in Einspannrichtung vorgesehen ist.

7. Vakuumbehandlungsanlage nach einem der vorhergehenden Ansprüche, **dadurch gekennzeichnet, dass**
die erste Zuleitung (4) an einer Platte (17) angeordnet ist und die Abstandselemente (18, 19) an der Platte (17) angeordnet sind, wobei entweder die Platte (17) selbst oder eine zwischen Platte (17) und erster Zuleitung (4) angeordnete Zwischenlage (16) elektrisch isolierend ist, so dass die Vorrichtung zum Führen der ersten Zuleitung (4) von der ersten Zuleitung (4) elektrisch isoliert ist.

8. Vakuumbehandlungsanlage nach Anspruch 7, **dadurch gekennzeichnet, dass**
zwei horizontale Anschläge durch zwei Backen und komplementäre, an der Platte (17) vorstehende Vorsprünge (24, 25) gebildet sind, wobei die Backen an dem oder den vertikalen Anschlagselementen (20, 21) angeordnet sind.

9. Vakuumbehandlungsanlage nach einem der vorhergehenden Ansprüche, **dadurch gekennzeichnet, dass**
eine Druckfeder (26) vorgesehen ist, die die erste Zuleitung (4) in der Einspannrichtung (A) in Richtung auf die zweite Zuleitung (5) zu verschiebt.

10. Vakuumbehandlungsanlage nach Anspruch 9, **dadurch gekennzeichnet, dass** zur Be- und Entlastung der Druckfeder (26) ein pneumatisches Element (30) vorgesehen ist.

11. Vakuumbehandlungsanlage nach einem der vorhergehenden Ansprüche, **dadurch gekennzeichnet, dass**
die erste Zuleitung (4) einen ersten Teil (13) umfasst, der vorzugsweise aus Kupfer besteht, und einen daran befestigbaren zweiten Teil (6), wobei der zweite Teil als Strombolzen (6) ausgebildet ist.

12. Vakuumbehandlungsanlage nach Anspruch 11, **dadurch gekennzeichnet, dass**
der Strombolzen (6) über einen Losflansch (10) an dem ersten Teil (13) befestigbar ist, so dass der Strombolzen (6) stufenlos gegenüber dem ersten Teil (13) verdreht werden kann.

13. Vakuumbehandlungsanlage nach Anspruch 11 oder 12, **dadurch gekennzeichnet, dass**
die zweite Zuleitung (5) einen Massebolzen (7) aufweist und der Massebolzen (7) und/oder der Strombolzen (6) mehrere backenförmige Aufnahmen (8, 9) für das Verdampferschiffchen (3) aufweisen.

14. Vakuumbehandlungsanlage nach Anspruch 13, **dadurch gekennzeichnet, dass**
der Massebolzen (7) vier drehsymmetrisch angeordnete backenförmige Aufnahmen (9) längs eines quadratischen Sockels (32) aufweist und die backenförmige Aufnahme (8) des Strombolzens (6) durch einen ring- oder kreisförmigen Sockel (31) ausgebildet ist.

15. Vakuumbehandlungsanlage nach einem der Ansprüche 11 bis 14, **dadurch gekennzeichnet, dass**
die erste Zuleitung (4) eine Wasserkühlung aufweist, die in dem zweiten Teil (13) vorzugsweise als eine Sacklochbohrung mit einem Kühlmittelverteilerrohr ausgebildet ist.

16. Vakuumbehandlungsanlage nach einem der Ansprüche 1 bis 15, **dadurch gekennzeichnet, dass**
der Verdampfer (1) innerhalb der Vakuumbehandlungsanlage in Bezug auf ein zu bedampfendes Substrat justierbar, insbesondere bezüglich des Abstands zum Substrat, ausgebildet ist.

17. Verdampfer (1) für Vakuumbeschichtungsanlagen, insbesondere für Reihenverdampfer in Bandbeschichtungsanlagen, der
die auf einen Verdampfer (1) gerichteten Merkmale von mindestens einem der vorherigen Ansprüche 1 bis 16 aufweist.

## Claims

1. A vacuum treatment plant, in particular a roll coating plant, having at least one evaporator (1) disposed within a process chamber (2), said evaporator comprising an evaporation boat (3) that can be controlled in terms of its power and which is heated by the passage of current, said evaporator further comprising two electrical supply lines (4, 5) between which said evaporation boat (3) can be gripped, said first supply line (4) being movable with respect to said second supply line (5) in a gripping direction (A), and said evaporator further comprising a device for guiding said first supply line (4) so as to grip and position said evaporation boat (3) between said supply lines (4, 5),
**characterized in that**
said device for guiding said first supply line (4) comprises at least two spacers (18, 19) and a base (22), and said first supply line (4) is movably connected to said base (22) via said spacers (18, 19), said spacers (18, 19) being placed on one side each with said first supply line (4) and with the other side on said base (22), thereby enabling said first supply line (4) to be forcibly guided, said spacers (18, 19) having such a length and configuration between said first supply line (4) and said base (22) that the guidance direction (B) is essentially parallel to the gripping direction (A) at least across a small deflection range of said spacers (18, 19).

2. A vacuum treatment plant in accordance with claim 1, **characterized in that** at least one spacer is designed to be rigid and is positioned on said first supply line (4) and said base (22) by means of hinged connections.

3. A vacuum treatment plant in accordance with claim 1 or 2, **characterized in that**
means for providing a pre-tension, particularly a pre-tension of 50 N, are provided in the gripping direction (A) and at least against said second supply line (5).

4. A vacuum treatment plant in accordance with any one of claims 1 to 3, **characterized in that**
at least one spacer (18, 19) is designed as a leaf spring that provides a pre-tension in the gripping direction (A) and at least against said second supply line (5).

5. A vacuum treatment plant in accordance with any of the preceding claims,
**characterized in that**
at least one vertical limit stop member (20, 21) is provided for limiting a movement of said first supply line (4) towards said base (22).

6. A vacuum treatment plant in accordance with any of the preceding claims,
**characterized in that**
at least one horizontal limit stop (20, 24, 21, 25) is provided for limiting the movement of said first supply line (4) in the gripping direction.

7. A vacuum treatment plant in accordance with any of the preceding claims,
**characterized in that**
said first supply line (4) is disposed on a plate (17) and said spacers (18, 19) are disposed on said plate (17), either said plate (17) itself or an intermediate shim (16) interposed between said plate (17) and first supply line (4) being electrically insulating so that said device for guiding said first supply line (4) is electrically insulated from said first supply line (4).

8. A vacuum treatment plant in accordance with claim 7, **characterized in that** two horizontal limit stops are formed by two jaws and complementary projections (24, 25) protruding at said plate (17), said jaws being disposed on said vertical limit stop member or members (20, 21).

9. A vacuum treatment plant in accordance with any of the preceding claims,
**characterized in that**
a compression spring (26) is provided, said spring moving said first supply line (4) in the gripping direction (A) towards said second supply line (5).

10. A vacuum treatment plant in accordance with claim 9, **characterized in that** a pneumatic member (30) is provided to apply a load to said compression spring (26) or relieve it of a load.

11. A vacuum treatment plant in accordance with any of the preceding claims,
**characterized in that**
said first supply line (4) comprises a first member (13) that is preferably made of copper, and a second member (6) attachable thereto, said second member being formed as a current pin (6).

12. A vacuum treatment plant in accordance with claim 11, **characterized in that** said current pin (6) is attachable to said first member (13) via a loose flange (10) so that said current pin (6) can be rotated with respect to said first member (13) in a continuously variable manner.

13. A vacuum treatment plant in accordance with claim 11 or 12, **characterized in that**
said second supply line (5) comprises an earth pin (7) and said earth pin (7) and/or said current pin (6) comprise/comprises a plurality of jaw-like carriers (8, 9) for said evaporation boat (3).

14. A vacuum treatment plant in accordance with claim 13, **characterized in that** said earth pin (7) comprises four jaw-like carriers (9) arranged in a rotationally symmetrical manner along a quadratic base (32) and said jaw-like carrier (8) of said current pin (6) is formed by an annular or circular base (31).

15. A vacuum treatment plant in accordance with any one of claims 11 to 14,
**characterized in that**
said first supply line (4) comprises a water cooling system that is preferably designed within said second member (13) as a blind-end bore having a coolant distributor pipe.

16. A vacuum treatment plant in accordance with any one of claims 1 to 15, **characterized in that**
said evaporator (1) within said vacuum treatment plant is designed to be adjustable in relation to a substrate that is to be sputtered, particularly relative to the distance to the substrate.

17. An evaporator (1) for vacuum coating facilities, particularly for line evaporators in roll coating facilities
**having**
the features of at least one of the preceding claims 1 to 16, said features being directed at an evaporator (1).

## Revendications

1. Installation de traitement sous vide, en particulier ligne de couchage sur bande, comprenant au moins un évaporateur (1) disposé dans une chambre de processus (2), évaporateur qui présente une nacelle d'évaporation (3) réglable dans sa puissance et chauffée par le passage de courant, deux conduites d'alimentation électriques (4, 5) entre lesquelles peut être fixée la nacelle d'évaporation (3), où la première conduite d'alimentation (4) est mobile par rapport à la deuxième conduite d'alimentation (5), dans une direction de fixation (A), ainsi qu'un dispositif servant au guidage de la première conduite d'alimentation (4), pour la fixation et le positionnement de la nacelle d'évaporation (3) entre les conduites d'alimentation (4, 5),
**caractérisée en ce que** le dispositif servant au guidage de la première conduite d'alimentation (4) comporte au moins deux éléments d'espacement (18, 19) et une base (22), et la première conduite d'alimentation (4) est raccordée à la base (22), de façon mobile, par les éléments d'espacement (18, 19), où les éléments d'espacement (18, 19) sont disposés sur respectivement un côté comprenant la première conduite d'alimentation (4) et sur la base (22) comprenant respectivement l'autre côté et, ainsi, permettent un guidage forcé de la première conduite d'alimentation (4), et où les éléments d'espacement (18, 19) présentent une longueur et un agencement tels entre la première conduite d'alimentation (4) et la base (22), que la direction de guidage (B) est sensiblement parallèle à la direction de fixation (A), au moins sur une petite zone de déviation des éléments d'espacement (18, 19).

2. Installation de traitement sous vide selon la revendication 1, **caractérisée en ce qu'**au moins un élément d'espacement est réalisé de façon rigide et disposé sur la première conduite d'alimentation (4) et la base (22), au moyen de joints articulés.

3. Installation de traitement sous vide selon la revendication 1 ou 2, **caractérisée en ce qu'**il est prévu des moyens servant à fournir une force de précontrainte, en particulier une force de précontrainte de 50 N, dans la direction de fixation (A) et au moins dans le sens inverse de la deuxième conduite d'alimentation (5).

4. Installation de traitement sous vide selon l'une des revendications 1 à 3, **caractérisée en ce qu'**au moins un élément d'espacement (18, 19) est réalisé comme un ressort à lames, élément d'espacement qui fournit une force de précontrainte dans la direction de fixation (A) et au moins dans le sens inverse de la deuxième conduite d'alimentation (5).

5. Installation de traitement sous vide selon l'une des revendications précédentes, **caractérisée en ce qu'**il convient de prévoir au moins un élément vertical (20, 21) formant butée, pour la limitation d'un mouvement de la première conduite d'alimentation (4) en direction de la base (22).

6. Installation de traitement sous vide selon l'une des revendications précédentes, **caractérisée en ce qu'**il est prévu au moins une butée horizontale (20, 24, 21, 25) servant à la limitation du déplacement de la première conduite d'alimentation (4), dans la direction de fixation.

7. Installation de traitement sous vide selon l'une des revendications précédentes, **caractérisée en ce que** la première conduite d'alimentation (4) est disposée sur une plaque (17), et les éléments d'espacement (18, 19) sont disposés sur la plaque (17), où soit la plaque (17) elle-même, soit une couche intermédiaire (16) disposée entre la plaque (17) et la première conduite d'alimentation (4), est électriquement isolante, de sorte que le dispositif servant au guidage de la première conduite d'alimentation (4) est isolé électriquement de la première conduite d'alimentation (4).

8. Installation de traitement sous vide selon la revendication 7, **caractérisée en ce que** deux butées horizontales sont formées par deux mâchoires et par des parties saillantes complémentaires (24, 25) dépassant de la plaque (17), où les mâchoires sont disposées sur le ou les éléments verticaux (20, 21) formant butée.

9. Installation de traitement sous vide selon l'une des revendications précédentes, **caractérisée en ce qu'**il est prévu un ressort de compression (26) qui déplace la première conduite d'alimentation (4), se trouvant dans la direction de fixation (A), en direction de la deuxième conduite d'alimentation (5).

10. Installation de traitement sous vide selon la revendication 9, **caractérisée en ce qu'**il est prévu un élément pneumatique (30) pour la charge et la décharge du ressort de compression (26).

11. Installation de traitement sous vide selon l'une des revendications précédentes**, caractérisée en ce que** la première conduite d'alimentation (4) comprend une première partie (13) qui, de préférence, est en cuivre, et une deuxième partie (6) pouvant être fixée sur la première partie, où la deuxième partie est configurée comme un boulon connecteur (6).

12. Installation de traitement sous vide selon la revendication 11, **caractérisée en ce que** le boulon connecteur (6) peut être fixé sur la première partie (13), par une bride libre (10), de sorte que le boulon connecteur (6) peut être tourné en continu par rapport à la première partie (13).

13. Installation de traitement sous vide selon la revendication 11 ou 12, **caractérisée en ce que** la deuxième conduite d'alimentation (5) comporte un boulon (7) de mise à la masse et le boulon (7) de mise à la masse et / ou le boulon connecteur (6) comportent plusieurs logements (8, 9) en forme de mâchoire, pour la nacelle d'évaporation (3).

14. Installation de traitement sous vide selon la revendication 13, **caractérisée en ce que** le boulon (7) de mise à la masse comporte, le long d'un socle carré (32), quatre logements (9) en forme de mâchoire, disposés en étant symétriques en rotation, et le logement (8) en forme de mâchoire du boulon connecteur (6) est constitué par un socle (31) de forme annulaire ou circulaire.

15. Installation de traitement sous vide selon l'une des revendications 11 à 14, **caractérisée en ce que** la première conduite d'alimentation (4) comporte un refroidissement à eau qui, dans la deuxième partie (13), est configuré de préférence comme un perçage borgne comprenant un tuyau distributeur de liquide de refroidissement.

16. Installation de traitement sous vide selon l'une des revendications 1 à 15, **caractérisée en ce que** l'évaporateur (1), à l'intérieur de l'installation de traitement sous vide, est configuré de façon réglable par rapport à un substrat à métalliser sous vide, en particulier relativement à l'intervalle par rapport au substrat.

17. Evaporateur (1) pour des installations de revêtement sous vide, en particulier pour des évaporateurs montés en série dans des lignes de couchage sur bande, qui présente des caractéristiques d'au moins l'une des revendications précédentes 1 à 16 concernant un évaporateur (1).
